(19) **Europäisches Patentamt / European Patent Office / Office européen des brevets**

(11) **EP 4 246 418 A1**

(12) # EUROPEAN PATENT APPLICATION
published in accordance with Art. 153(4) EPC

(43) Date of publication:
**20.09.2023 Bulletin 2023/38**

(21) Application number: **21911536.7**

(22) Date of filing: **22.12.2021**

(51) International Patent Classification (IPC):
**G06Q 50/08** (2012.01)      **G06Q 50/10** (2012.01)
**G06T 19/00** (2011.01)      **G06F 30/20** (2020.01)
**G06Q 10/06** (2023.01)      **G06N 3/08** (2023.01)

(52) Cooperative Patent Classification (CPC):
**G06F 30/20; G06N 3/08; G06Q 10/06; G06Q 50/08; G06Q 50/10; G06T 19/00**

(86) International application number:
**PCT/KR2021/019629**

(87) International publication number:
**WO 2022/139469 (30.06.2022 Gazette 2022/26)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **23.12.2020 KR 20200181469**

(71) Applicant: **Urbanbase Inc.**
**Seoul 06614 (KR)**

(72) Inventor: **KIM, Soo Min**
**Seoul 03916 (KR)**

(74) Representative: **BCKIP Part mbB**
**Siegfriedstraße 8**
**80803 München (DE)**

(54) **DEVICE AND METHOD FOR PROVIDING OBJECT PLACEMENT MODEL OF INTERIOR DESIGN SERVICE ON BASIS OF REINFORCEMENT LEARNING**

(57)    An object placement model providing method according to an embodiment of the present invention may comprise the steps of: generating a variable configuring a state of a virtual space, a control operation changing the variable of the virtual space, an agent which is an object subjected to the control operation in the virtual space, a policy defining an effect of a predetermined variable on another variable, and a training environment subjected to reinforcement learning; generating a first neural network which trains a value function predicting a reward; generating a second neural network which trains a policy function determining a control operation to maximize finally accumulated rewards among available control operations on the basis of a prediction value of the value function for each state changed by the available control operations; and performing reinforcement learning to minimize cost functions of the first neural network and the second neural network.

Fig. 1

EP 4 246 418 A1

**Description**

[Technical Field]

The present disclosure relates to an object placement model provision device and method of a reinforcement learning-based interior service.

[Background]

People have a desire to pursue a more beautiful residential environment while conforming to their personalities as they live. To this end, an interior space is simply decorated by arranging new objects in the residential space, or furthermore, interior construction such as replacing wallpaper or flooring and changing the structure of the space is carried out.

Conventionally, for interior construction, a client requests an interior design expert to design an interior space for a residential environment to create a desired space, and the requested interior design expert designs an interior space desired by the customer and presents the design to the customer.

However, as interior design services (e.g., 3D space data platform Urban Base) have been developed that allow users to decorate various interior design elements in a virtual space, users of interior design services are capable of arranging objects and easily replace the flooring/wallpaper in the virtual space in which a living environment of the users is directly transplanted, according to their preference.

Accordingly, users may indirectly experience a real interior space through an interior design service of the virtual space, and are provided with services such as ordering a real interior product that they like or placing an order for interior design linked to actual construction.

[Detailed Description]

[Technical Problem]

The above-described interior design service provides an interior design element such as various types of objects, flooring, and wallpaper to a virtual space of a user such that the user is capable of directly decorating various interior design elements in virtual space.

Arrangement of interior design elements is import in both aesthetic and practical aspects, and in this regard, when an interior design service user is not an interior design expert, it may be difficult to select numerous types of objects, flooring materials, and wallpaper.

Accordingly, an object of an embodiment of the present disclosure is to provide a technology for automatically recommending a location in which interior design elements are to be placed in consideration of the harmony and movement lines of objects in a virtual space of a user using an interior design service.

However, the technical objects to be achieved by the embodiments of the present disclosure are not limited to the above-mentioned objects, and various technical objects may be derived from the contents to be described below within the scope obvious to one of skill in the art.

[Technical Solution]

According to an embodiment of the present disclosure, an object placement model provision device includes one or more memories configured to store instructions for performing a predetermined operation, and one or more processors operatively connected to the one or more memories and configured to execute the instructions, wherein the operation performed by the processor includes generating a learning environment as a target of reinforcement learning by setting variable constituting a state of a virtual space provided by an interior design service, a control action of changing a variable of the virtual space, an agent as a target object of the control action, placed in the virtual space, a policy defining an effect of a predetermined variable on another variable, and a reward evaluated based on the state of the virtual space changed by the control action, generating a first neural network configured to train a value function predicting a reward to be achieved as a predetermined control action is performed in each state of the learning environment, generating a second neural network configured to train a policy function determining a control action of maximizing a reward to be finally accumulated among control actions to be performed, based on a predicted value of the value function for each state changed by a control action to be performed in each state of the learning environment, and performing reinforcement learning in a direction of minimizing a cost function of the first neural network and the second neural network.

The variable may include a first variable specifying a location, an angle, and an area of a wall and a floor constituting the virtual space, and a second variable specifying a location, an angle, and an area of an object placed in the virtual space.

The first variable may include a position coordinate specifying a midpoint of the wall, a Euler angle specifying an angle at which the wall is disposed, a center coordinate of the floor, and polygon information specifying a boundary surface of the floor.

The second variable may include a position coordinate specifying a midpoint of the object, size information specifying a size of a horizontal length/vertical length/width of the object, a Euler angle specifying an angle at which the object is disposed, and interference information used to evaluate interference between the object and another object.

The interference information may include information on a space occupied by a polyhedral shape that protrudes by a volume obtained by multiplying an area of any one of surfaces of a hexahedron including a midpoint of the object within the size of the horizontal length/vertical length/width by a predetermined length.

The policy may classify an object that is in contact with a floor or a wall in the virtual space to support another object among the objects, as a first layer, classify an object that is in contact with an object of the first layer to be supported among the objects, and include a first policy predefined with respect to a type of an object of the second layer that is associated and placed with a predetermined object of the first layer and is set as a relationship pair therewith, a placement distance between the predetermined object of the first layer and the object of the second layer as a relationship pair therewith, and a placement direction of the predetermined object of the first layer and the object of the second layer as a relationship pair therewith, a second policy predefining a range of a height at which a predetermined object is disposed, and a third policy predefining and recognizing a movement line that reaches all types of spaces from an entrance of the virtual space as an area with a predetermined width.

The control action may include an operation of changing a variable for a location and an angle of the agent in the virtual space.

The reward may be calculated according to a plurality of preset evaluation equations for evaluating respective degrees to which the state of the learning environment, which is changed according to the control action, conforms to each of the first, second, and third policies, and may be determined by combining respective weights determined as reflection ratios of the plurality of evaluation equations.

The plurality of evaluation equations may include an evaluation score for a distance between objects in the virtual space, an evaluation score for a distance between object groups obtained after the object in the virtual space is classified into a group depending on the distance, an evaluation score for an alignment relationship between the objects in the virtual space, an evaluation score for an alignment relationship between the object groups, an evaluation score for an alignment relationship between the object group and the wall, an evaluation score for a height at which an object is disposed, an evaluation score for a free space of the floor, an evaluation score for a density of an object disposed on the wall, and an evaluation score for a length of a movement line.

An object placement model provision device may include a memory configured to store an object placement model generated by the device, an input interface configured to receive a placement request for a predetermined object from a user of an interior design service, and a processor configured to generate a variable specifying information on a state of a virtual space of the user and information on the predetermined object and then determine a placement space for the predetermined object in the virtual space based on a control action output by inputting the variable to the object placement model.

According to an embodiment of the present disclosure, an object placement model provision method includes generating a learning environment as a target of reinforcement learning by setting variable constituting a state of a virtual space provided by an interior design service, a control action of changing a variable of the virtual space, an agent as a target object of the control action, placed in the virtual space, a policy defining an effect of a predetermined variable on another variable, and a reward evaluated based on the state of the virtual space changed by the control action, generating a first neural network configured to train a value function predicting a reward to be achieved as a predetermined control action is performed in each state of the learning environment, generating a second neural network configured to train a policy function determining a control action of maximizing a reward to be finally accumulated among control actions to be performed, based on a predicted value of the value function for each state changed by a control action to be performed in each state of the learning environment, and performing reinforcement learning in a direction of minimizing a cost function of the first neural network and the second neural network.

[Advantageous Effect]

An embodiment of the present disclosure may provide an optimal object placement technology in consideration of the size occupied by an object in the virtual space of the interior design service, interference between objects, a type of objects placed together, a movement line of the virtual space, and the like based on the reinforcement learning.

In addition, various effects to be directly or indirectly identified through this document may be provided.

[Brief Description of Drawings]

FIG. 1 is a functional block diagram of an object placement model provision device according to an embodiment of the present disclosure.

FIG. 2 is an operation flowchart of an object placement model provision method for performing learning on an object placement model by the object placement model provision device according to an embodiment of the present disclosure.

FIG. 3 is an exemplary diagram of a virtual space in a learning environment according to an embodiment of the present disclosure.

FIG. 4 is an exemplary diagram of an operation of specifying an object in a learning environment according to an embodiment of the present disclosure.

FIG. 5 is an exemplary diagram of information predefined for an object of a first layer and an object of a second layer that correspond to a relationship pair in a learning environment according to an embodiment of the present disclosure.

FIG. 6 is an exemplary diagram for explaining an operation of training a value function and a policy function based on reinforcement learning according to an embodiment of the present disclosure.

FIG. 7 is an operation flowchart of a method of providing an object placement model in which an object placement model provision device determines a location in which an object is to be placed through an object placement model according to an embodiment of the present disclosure.

[Best Mode]

The attached drawings for illustrating exemplary embodiments of the present disclosure are referred to in order to gain a sufficient understanding of the present disclosure, the merits thereof, and the objectives accomplished by the implementation of the present disclosure. The present disclosure may, however, be embodied in many different forms and should not be construed as being limited to the embodiments set forth herein; rather, these embodiments are provided so that this disclosure will be thorough and complete, and will fully convey the concept of the present disclosure to one of ordinary skill in the art. Meanwhile, the terminology used herein is for the purpose of describing particular embodiments and is not intended to limit the present disclosure.

In the following description of the present disclosure, a detailed description of known functions and configurations incorporated herein will be omitted when it may make the subject matter of the present disclosure unclear. The terms used in the specification are defined in consideration of functions used in the present disclosure, and can be changed according to the intent or conventionally used methods of clients, operators, and users. Accordingly, definitions of the terms should be understood on the basis of the entire description of the present specification.

The functional blocks shown in the drawings and described below are merely examples of possible implementations. Other functional blocks may be used in other implementations without departing from the spirit and scope of the detailed description. In addition, although one or more functional blocks of the present disclosure are represented as separate blocks, one or more of the functional blocks of the present disclosure may be combinations of various hardware and software configurations that perform the same function.

The expression that includes certain components is an open-type expression and merely refers to existence of the corresponding components, and should not be understood as excluding additional components.

It will be understood that when an element is referred to as being "on", "connected to" or "coupled to" another element, it may be directly on, connected or coupled to the other element or intervening elements may be present.

Expressions such as 'first, second', etc. are used only for distinguishing a plurality of components, and do not limit the order or other characteristics between the components.

Hereinafter, embodiments of the present disclosure will be described with reference to the accompanying drawings.

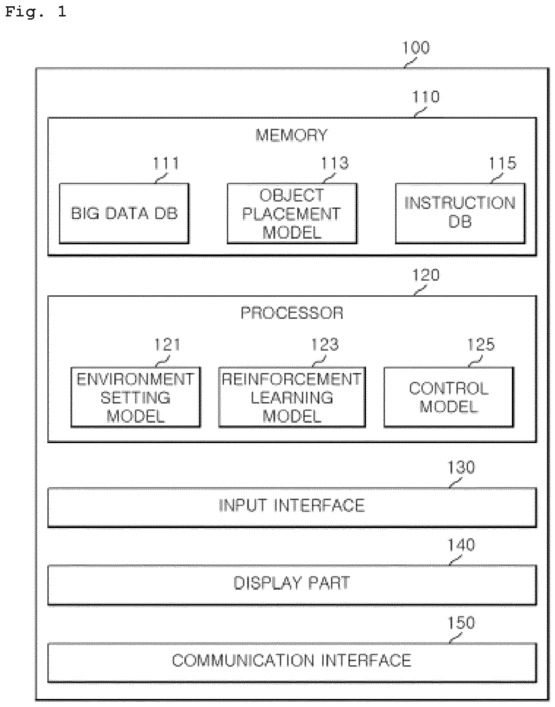

FIG. 1 is a functional block diagram of an object placement model provision device 100 according to an embodiment of the present disclosure. Referring to FIG. 1, the object placement model provision device 100 according to an embodiment may include a memory 110, a processor 120, an input interface 130, a display part 140, and a communication interface 150.

The memory 110 may include a big data database (DB) 111, an object placement model 113, and an instruction DB 115.

The big data DB 111 may include various data collected from an interior design service. The interior design service may include a service that provides a function for decorating a virtual interior design element by transplanting an image of a real space into a three-dimensional virtual space. Users who use the interior design service may place interior design elements such as object/flooring/wallpaper in the virtual space according to his or her preference. The users using the interior design service may see interior design of a virtual space decorated by other users and respond through an empathy function (e.g., like button). In addition, the number of searches by users for a specific interior design may be counted through the interior design service.

The big data DB 111 may store all information collected from the interior design service as big data. For example, big data may include information on a user of the interior design service, information on an interior space designed by the user, information on a room type of interior design, information on an object, wallpaper, and flooring placed by the user, information on user preference, information on evaluation of the user of a specific interior design, and information on the number of times users searches for a specific interior design.

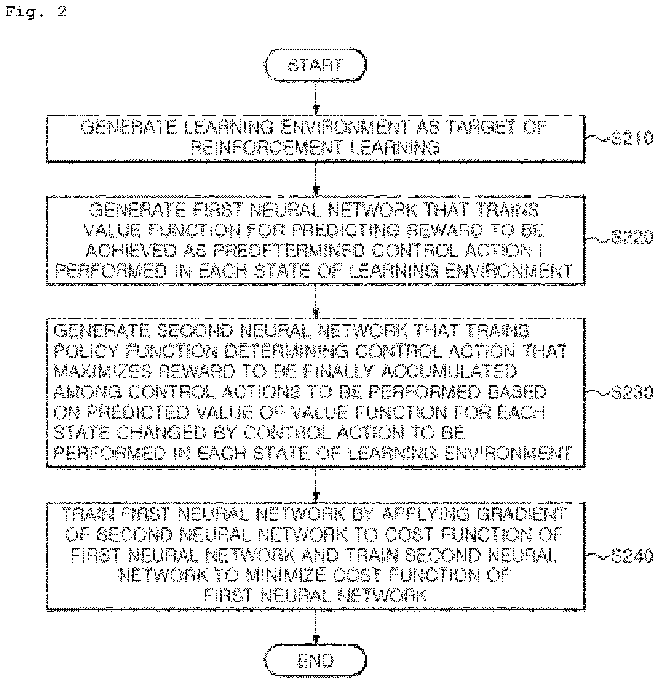

The object placement model 113 is an artificial intelligence (AI) model that recommends an optimal location and direction for placing interior design elements to a user of an interior design service in consideration of the size of an occupied object, interference between objects, the harmony of objects placed together, the density of placement, and movement lines in a space as objects are placed in a virtual space of a reinforcement learning-based interior design service. The object placement model 113 may be trained and stored in the memory 110 according to an embodiment to be described later with FIG. 2.

In an embodiment of the present disclosure, reinforcement learning is used to generate an object placement model for determining a control action (e.g., determination of a location and an angle) for determining a location at which an agent as a control target (e.g., an object to be placed in a virtual space) is to be placed in order to achieve the purpose of placing an object at an optical object in consideration of harmony with other objects, interference, and movement lines of the corresponding object when a specific object is placed in the virtual space of the interior design service. For example, in the embodiment of the present disclosure, a reinforcement learning algorithm may use an advantage actor-critic (A2C) model, but the embodiment of the present disclosure is not limited to this example and various algorithms based on the concept of reinforcement learning may be applied to the embodiment of the present disclosure.

The instruction DB 115 may store instructions for performing an operation of the processor 120. For example, the instruction DB 115 may store a computer code for performing operations corresponding to the operation of the processor 120 to be described later.

The processor 120 may control overall operations of components included in the object placement model provision device 100, the memory 110, the input interface 130, the display part 140, and the communication interface 150. The processor 120 may include an environment setting module 121, a reinforcement learning module 123, and a control module 125. The processor 120 may execute the instructions stored in the memory 110 to drive the environment setting module 121, the reinforcement learning module 123, and the control module 125. Operations performed by the environment setting module 121, the reinforcement learning module 123, and the control module 125 may be understood as operations performed by the processor 120.

The environment setting module 121 may generate a learning environment for reinforcement learning of an object placement model. The learning environment may include information on an environment preset to train an object placement model. For example, the environment setting module 121 may generate a learning environment by setting a variable constituting a state of a virtual space provided by the interior design service, a state expressed as a combination of these variable values, a control action for changing a variable constituting the state of the virtual space, an agent that is a target of the control action, a policy that defines an effect of a certain variable on another variable, and a reward evaluated based on the state of the virtual space changed by the control action.

The reinforcement learning module 123 may generate an object placement model on which reinforcement learning is performed by training a value function that predicts a reward to be achieved by performing a predetermined control action in each state of a learning environment when the setting of the learning environment is complete, and a policy function that determines the control action for maximizing the reward to be finally accumulated among control actions to be performed based on a predicted value of the value function for each state changed by the control action to be performed in each state of the learning environment.

The control module 125 may recommend an optimal object placement space by utilizing an object placement model when a user requests placement of a specific object in the virtual space of the interior design service.

The input interface 130 may receive user input. For example, the input interface 130 may receive an input such as an interior design element selected by a user from the interior design service.

The display part 140 may include a hardware component that includes a display panel and outputs an image.

The communication interface 150 may communicate with an external device (e.g., an external DB server and a user equipment (UE)) to transmit and receive information. To this end, the communication interface 150 may include a wireless communication module or a wired communication module.

Hereinafter, with reference to FIGS. 2 to 7, a detailed embodiment in which components of the object placement model provision device 100 are operatively associated to train and use an object placement model will be described.

FIG. 2 is an operation flowchart of an object placement model provision method for performing learning on an object placement model by the object placement model provision device 100 according to an embodiment of the present disclosure. Each operation of the object placement model provision method according to FIG. 2 may be performed by the components of the object placement model provision device 100 described with reference to FIG. 1, and is described as follows.

The environment setting module 121 may generate a learning environment to be subjected to reinforcement learning (S210). For example, the environment setting module 121 may set a variable constituting the state of a virtual space provided by the interior design service, a control action for changing a variable of a virtual space, an agent that is a target of the control action, a policy that defines an effect of a certain variable on another variable, and a reward evaluated based on the state of the virtual space changed by the control action.

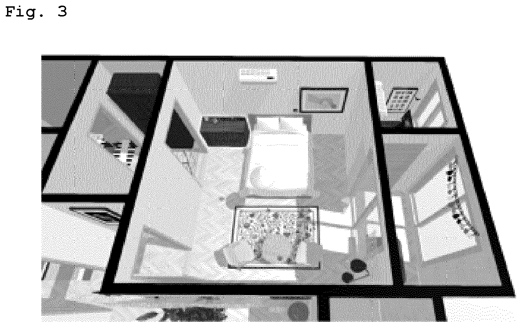

The variable may include identification information on the variable to indicate the state of the virtual space as shown in FIG. 3 (e.g., the size of a virtual space, the shape of the virtual space, the location of an object disposed in the virtual space, the size of an object, and the type of the object) and a value representing each variable. To this end, there are two types of variables, a first variable that specifies a virtual space of an interior design service, and a second variable that specifies the location, angle, occupied area, and interference area of objects placed in the virtual space.

The first variable may include 3D positional coordinates specifying a midpoint of a wall, the Euler angle specifying an angle at which the wall is placed, size information of a horizontal length/vertical length/width specifying the size of the wall, 3D positional coordinates specifying the center of the floor, and polygon information specifying a boundary surface of the floor. Accordingly, the virtual space may be specified by setting the location and arrangement angle of the floor and the wall, and the purpose of each space may be specified by dividing a space through the wall.

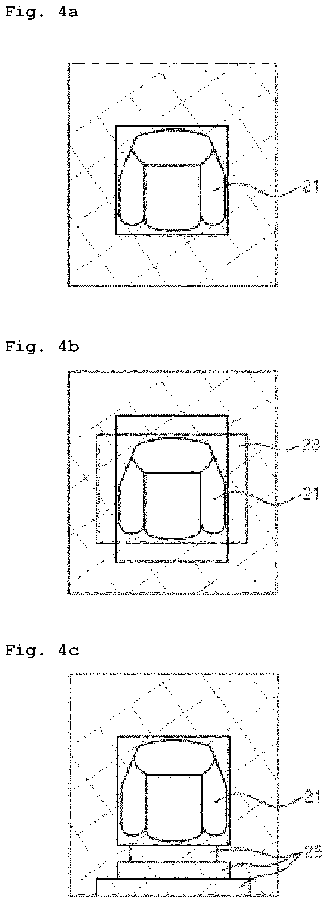

Referring to (a) of FIG. 4, the second variable may include a 3D position coordinate that specifies a midpoint of an object, size information that specifies the size of the horizontal length/vertical length/width of the object, and information on the Euler angle that specifies an angle at which the object is placed. Accordingly, the location and direction in which the object is placed may be specified through the midpoint of the object and the Euler angle, and a size occupied by the corresponding object may be specified (21) within a virtual space by specifying the size of a hexahedron including the midpoint of the object within the size of the horizontal length/vertical length/width through the size information.

Referring to (b) of FIG. 4, the second variable may include information an interference area, which is a virtual volume used to evaluate interference between a specific object and another object. The information on the interference area may specify (23) the volume of a space occupied by a polyhedral shape that protrudes by a volume obtained by multiplying the area of any one of surfaces of the hexahedron specifying the object by a predetermined distance in order to specify elements that ensure movement lines and avoid interference between objects.

Referring to (c) of FIG. 4, information on the interference area may specify (25) the volume of spaces that are sequentially occupied by a plurality of polyhedrons that protrude by a volume obtained by multiplying an area at a predetermined ratio with respect to any one of surfaces of a hexahedron specifying an object by a predetermined distance in order to specify an element representing a viewing angle.

The policy means information that defines the direction of learning, which state meets a learning purpose in the virtual space. To this end, the policy according to an embodiment of the present disclosure may include a first policy defining a desirable arrangement relationship between objects, a second policy defining a range for a desirable height of an object, and a third policy that ensures the shortest movement line from a first location to a second location.

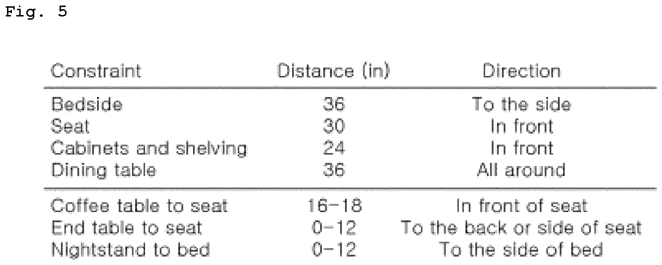

The first policy classifies an object that is in contact with a floor or a wall in a virtual space to support another object among objects of an interior design service, as a first layer and classifies an object that is in contact with the object of the first layer to be supported, as a second layer, and may include policy information defined as shown in FIG. 5 with respect to a type of the object of the second layer that is associated and placed with the object of the first layer and is set as a relationship pair, a placement distance between the object of the first layer and the object of the second layer as a relationship pair of the first layer, and a placement direction between the object of the first layer and the object of the second layer as a relationship pair of the first layer.

The second policy may include policy information defining a range of an appropriate height in which a predetermined object is disposed.

The third policy may include policy information that defines to recognize a movement line that reaches all types of spaces (e.g., living room, kitchen, bathroom, and bedroom) from a specific location as the shortest space as an area with a predetermined width.

The agent may be specified as an object to be placed in a virtual space, and may be a subject for which a control action is performed for determining a location, an angle, or the like to be placed in the virtual space based on a predefined policy and reward.

The reward may be calculated according to a plurality of preset evaluation equations for evaluating respective degrees to which the state of a learning environment (e.g., a combination of variables representing the virtual space), which is changed according to the control action for the agent, conforms to each of the first policy, the second policy, and the third policy and may be determined by summing the calculated values based on a weight that determines a ratio of reflecting an evaluation score calculated according to each evaluation equation.

For example, the reward may be determined by Equations 1 to 13 below.

[Equation 1]

$$C_{IF} = -\sum_{f1,f2 \subset F}((\textit{Objection Collision}) + w_p(\textit{Bounding Box Collision}))$$

($C_{IF}$: evaluation score for distance between objects, F: set of all things in virtual space, f1: first object, f2: second object, Objection Collision: Ratio of overlapping volume between first and second objects in virtual space, Bounding Box Collision: Ratio of overlapping volume between space corresponding to interference information of first object and space corresponding to interference information of second object in virtual space, and $w_p$ is 0 when first object and second object correspond to relationship pair and is 1 when first object and second object do not correspond to relationship pair)

[Equation 2]

$$C_{IG} = -\sum_{g1,g2 \subset G}(\textit{Bounding Box Collision})$$

($C_{IG}$: evaluation score for distance between object groups, and Bounding Box Collision: Ratio of overlapping volume between space corresponding to interference information of objects belonging to first group and space corresponding to interference information of objects belonging to second group in virtual space)
In this case, in Equation 2, a group of objects may be classified into groups of objects arranged close to each other by using a predetermined algorithm for grouping objects based on the location of 3D coordinates of the objects in the virtual space. To this end, various grouping algorithms may be used, and for example, a density based spatial clustering of applications with noise (DBSCAN) clustering algorithm may be used.

[Equation 3]

$$C_{AF} = \sum_{f1,f2 \subset F}\cos(4(f_1(\theta) + f_2(\theta)))$$

($C_{AF}$: evaluation score of alignment relationship between objects, F: set of all objects in virtual space, f1: first object, f2: second object, and $f_1(\theta) + f_2(\theta)$: angle formed by line connecting midpoint of first object and midpoint of second object with respect to predetermined axis (e.g., x or y axis))

[Equation 4]

$$C_{AG} = \begin{cases} 1, & \text{if } g_1(\theta) + g_2(\theta) = o° \ \text{ or } \ g_1(\theta) + g_2(\theta) = 90° \\ 0, & \textit{otherwise} \end{cases}$$

($C_{AG}$: evaluation score of alignment relationship between object groups, and g1($\theta$)+g2($\theta$): angle formed by line connecting midpoint of objects formed by first group and midpoint of objects formed by second group with respect to predetermined axis (e.g., x or y axis))

[Equation 5]

$$C_{AW} = -\sum_{G,W \subset F}\cos(4(G(\theta) + W(\theta)))$$

($C_{AW}$: evaluation score of alignment relationship between object group and wall, F: set of all objects in virtual space, G: group object formed in virtual space, W: wall in virtual space, G($\theta$)+W($\theta$): angle formed by line connecting midpoint of objects in group and midpoint of wall with respect to predetermined axis (e.g., x or y axis))

[Equation 6]

$$C_H = -\sum_{f \subset F}H(f) - F(h)$$

($C_H$: evaluation score for height in which object is disposed, F: set of all objects in virtual space, f: specific object, H(f): ratio of height by which specific object deviates from predefined appropriate height, and F(h): ratio of height by which average height of all objects deviates from predefined appropriate height for specific space (e.g., living room, bedroom, or bathroom)

[Equation 7]

$$C_{FAG} = Area(ground) - \sum_{g \subset G} Area(proj(B(g)))$$

($C_{FAG}$: evaluation score for free space on floor, Area (ground): total floor area, G: set of all groups in virtual space, g: specific group in virtual space, and Area (proj(B(g))): projected area on floor when sizes of all objects belonging to specific group are projected onto floor)

[Equation 8]

$$C_{FAW} = \sum_{w \subset W} K_w * \{Area(w) - \sum_{f \subset w} Area(proj(B(f)))\}$$

($C_{FAW}$: Evaluation score for whether objects are densely placed on wall, W: set of all walls in virtual space, w: specific wall in virtual space, $K_w$: number of objects placed on wall w at predetermined distance or less, f: object placed on wall w at predetermined distance or less, Area(w): area of wall w, and Area(proj(B(f))): projected area on wall when size of object placed wall w at predetermined distance or less are projected onto wall w)

[Equation 9]

$$C_C = - Length(Circulation\ Curve)$$

($C_c$: evaluation score for length of movement line, and Length (Circulation Curve): length of line connecting preset first location (e.g., entrance) and preset second location (e.g., window, living room, kitchen, bathroom, or bedroom))

At this time, in Equation 9, the total length may be calculated by applying a Voronoi Diagram algorithm to information on a midpoint specifying each of the first location and the second location.

[Equation 10]

$$G = C_{If} + C_H + C_{Af} + C_{FAW}$$

Equation 10 relates to an evaluation score obtained in consideration of a placement distance between objects, a placement height, an alignment relationship between objects, and a placement density of an object and a wall based on each object.

[Equation 11]

$$P = C_{IG} + C_{AG} + C_{Aw} + C_{FAG}$$

Equation 11 relates to an evaluation score obtained in consideration of a placement distance between groups, an alignment relationship between groups, an alignment relationship between a group and a wall, and a placement density of a group and a wall based on a group of an object.

[Equation 12]

$$C = C_c$$

Equation 12 relates to an evaluation score obtained in consideration of efficiency of a movement line as an object is placed.

[Equation 13]

$$R_{(s,a)} = w_G * G + w_{Pp} * P + w_{Cc} * C$$

($w_G$ is a reflection rate of evaluation score G, $w_{Pp}$ is a reflection rate of evaluation score P, and $w_{Cc}$ is a reflection rate of evaluation score C)

Accordingly, the reward may be calculated according to evaluation equations of Equation 1 to Equation 9 that are preset with respect to a degree by which a state of a learning environment changed by a control action conforms to each of the first, second, third policies, and a learning environment may be set to determine a final reward as in Equation 13 in consideration of a reflection ratio based on learning intention with respect to Equations 10, 11, and 12 evaluated based on respective standards.

As such, after setting of the learning environment is complete, the reinforcement learning module 123 may generate a first neural network that trains a value function for predicting a reward to be achieved according to a control action to be performed in each state of the learning environment (S220), and generate a second neural network that trains a policy function for deriving a control action that maximizes a reward to be finally accumulated among control actions to be performed in each state of the learning environment (S230).

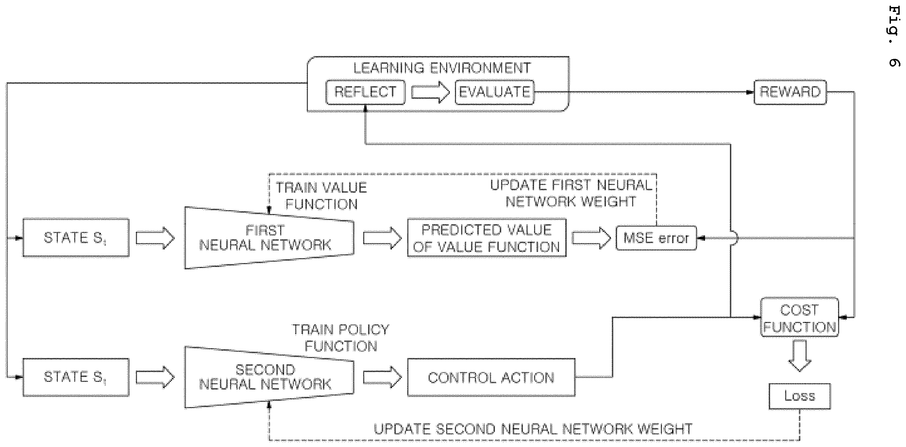

FIG. 6 is an exemplary diagram for explaining an operation of training a value function and a policy function based on an actor-critic algorithm in reinforcement learning according to an embodiment of the present disclosure.

The actor-critic algorithm as an embodiment of the reinforcement learning algorithm is an on-policy reinforcement learning algorithm that learns by modeling a policy and applying a gradient descent scheme to the policy function, and may learn an optimal policy through a policy gradient scheme.

An object placement model (e.g., actor-critic model) according to an embodiment of the present disclosure may include a first neural network and a second neural network. The first neural network may include a critic model that trains a value function that predicts a reward to be achieved as a predetermined control action is performed in each state of a learning environment. The control action may include a control action that changes a variable such as a location and angle at which an object to be controlled is to be placed.

The second neural network may include an actor model that trains a policy function that derives a control action that maximizes the reward to be finally accumulated among control actions to be performed in each state of the learning environment.

In this ca se, the policy is defined as $\pi_\theta(a_t \mid s_t)$ and is expressed as a conditional probability of the control action ($a_t$) for the current state ($s_t$). In addition, a state-action value function for a state and an operation is defined as $Q_w(s_t, a_t)$, and represents an expected value of the total reward to be obtained when a certain action ($a_t$) is performed in a certain state ($s_t$).

The reinforcement learning module 123 may set an input variable of a first neural network to the state $s_t$ of the learning environment and set an output variable of the first neural network to a reward to be achieved as a policy is performed in each state of the learning environment, i.e., a predicted value $V_w(s_t)$ of a value function. In this case, the input variable may be a variable constituting the learning environment and may be a combination of the first variable or the second variable.

A cost function that determines a learning direction of the first neural network may be a mean square error (MSE) function that minimizes a gain $A(s,a)$ indicating how much higher the predicted value ($V_w(s_t)$) of the value function than an actual value, and for example, may be set to Equation 14 below.

$$[Equation\ 14]$$
$$A(s,a) = Q_w(s_t, a_t) - V_w(s_t)$$
$$loss_{critic} = (r_{t+1} + \gamma V_w(s_{t+1}) - V_w(s_t))^2$$

In this case, $Q_w()$ is a state-action value function, w is a learned parameter, $s_t$ is a current state of a learning environment, $Q_w(s_t, a_t)$ is an expected value of the total reward for a control action ($a_t$) of a current state ($s_t$), $loss_{critic}$ is a cost function of the first neural network, $r_{t+1}$ is a reward acquired in a next state ($s_{t+1}$), $V_w(s_{t+1})$ is an expected value of the total reward for a policy of a next state ($s_{t+1}$), $V_w(s_t)$ is an expected value of the total reward for a policy of the current state ($s_t$), and $\gamma$ is a depreciation rate of learning.

Accordingly, the first neural network may update a parameter of the first neural network, such as a weight and a bias, in a direction for minimizing the cost function of the first neural network whenever the state of the learning environment changes.

The second neural network trains the policy function that derives a control action for maximizing the reward to be finally accumulated among control actions to be performed in each state of the learning environment. To this end, the input variable of the second neural network may be set to the predicted value of the value function and the state ($s_t$) of the learning environment, and the output variable of the second neural network may be set to be the control action that maximizes the reward to be finally accumulated among control actions to be performed in each state of the learning environment. In this case, the input variable may be a variable constituting the learning environment and may be a combination of the first variable or the second variable.

In this case, the second neural network may be learned based on a cost function in the form of, for example, Equation 15 below.

[Equation 15]

$$\nabla_\theta J(\theta, s_t) = - E[\nabla_\theta \log \pi_\theta(a_t \mid s_t) Q_w(s_t, a_t)]$$

In this case, $\nabla_\theta J(\theta, s_t)$ is a cost function of the second neural network, $\pi_\theta()$ is a policy function, $\theta$ is a parameter learned in the second neural network, $s_t$ is a current state of the learning environment, $\pi_\theta(a_t \mid s_t)$ is a conditional probability of the control action ($a_t$) in the current state ($s_t$), $Q_w()$ is a state-action value function, w is a learned parameter, $s_t$ is a current state of the learning environment, and $Q_w(s_t, a_t)$ is an expected value of the total reward for the control action ($a_t$) of the current state ($s_t$).

The output variable of the first neural network may be applied to the cost function of the second neural network and may be set as in Equation 16 below.

[Equation 16]

$$\nabla_\theta J(\theta, s_t) = - E[\nabla_\theta \log \pi_\theta(a_t \mid s_t) Q_w(s_t, a_t)]$$
$$= - E[\nabla_\theta \log \pi_\theta(a_t \mid s_t)(r_{t+1} + \gamma V_w(s_{t+1}) - V_w(s_t))]$$

In this case, $\nabla_\theta J(\theta, s_t)$ is a cost function of the second neural network,, $\pi_\theta()$ is a policy function, $\theta$ is a parameter learned in the second neural network, $s_t$ is a current state of the learning environment, $\pi_\theta(a_t \mid s_t)$ is a conditional probability of the control action ($a_t$) in the current state ($s_t$), $V_w()$ is a value function, w is a parameter learned in the first neural network, $V_w(S_t)$ is an expected value of the total reward for a policy of the current state ($s_t$), $r_{t+1}$ is a reward acquired in a next state ($s_{t+1}$), $V_w(s_{t+1})$ is an expected value of the total reward for a policy in the next state ($s_{t+1}$), $\gamma$ is a depreciation rate of learning in the first neural network ($s_{t+1}$).

Accordingly, the reinforcement learning module 123 may perform reinforcement learning in a direction for minimizing the cost function of the first neural network and the cost function of the second neural network (S240).

That is, in every state until the learning environment starts from an arbitrary starting state (or a state of a virtual space included in big data of the interior design service) and reaches an end state while the state changes according to a control action for a specific object, the value function may be updated to minimize the cost function of the first neural network, and the policy function may be updated in parallel to minimize the cost function of the second neural network by reflecting the updated value function to the cost function of the second neural network.

Accordingly, the second neural network may receive the current state ($s_t$) of the learning environment and derive the control action ($a_t$) with the largest reward to be accumulated from the current state of the learning environment to a final state based on the policy function.

Then, the learning environment changes the current state ($s_t$) to the next state ($s_{t+1}$) based on a set rule by the control action ($a_t$), and provides a variable constituting the next state ($s_{t+1}$) and a reward ($r_{t+1}$) of the next state to the first neural network. Accordingly, the first neural network may update the value function to minimize the cost function of the first neural network and provide an updated parameter to the second neural network, and the second neural network may update the policy function to minimize the cost function of the second neural network by applying the parameter of the updated value function to the cost function of the second neural network.

As such, the reinforcement learning module 123 may repeat the number of learning times of the first neural network and the second neural network according to the above-mentioned direction, and train the value function and the policy function to determine an optimal control action, and the object placement model may be understood as including the first neural network and the second neural network that perform learning several times. Accordingly, when an object is placed in a specific virtual space using an object placement model, an optimal location that meets a predefined policy may be calculated.

Equation 14 to Equation 16 described above are equations exemplified for explanation of reinforcement learning, and may be changed and used within an obvious range to implement an embodiment of the present disclosure.

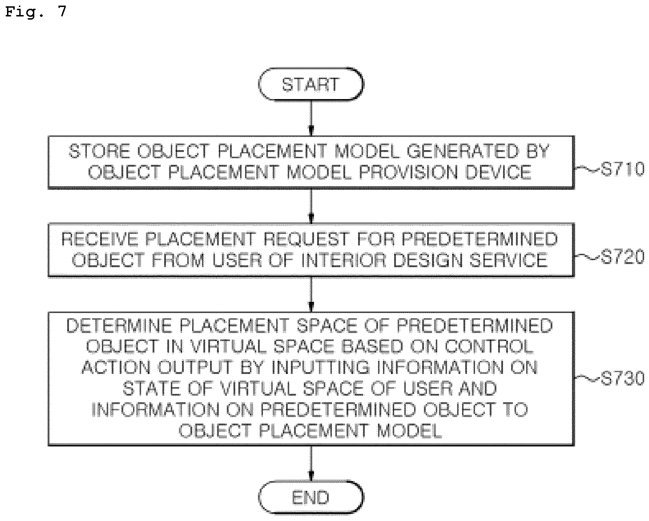

FIG. 7 is an operation flowchart of a method of providing an object placement model in which the object placement model provision device 100 determines a location in which an object is to be placed through an object placement model according to an embodiment of the present disclosure. However, a use operation of the object placement model according to FIG. 7 may not necessarily need to be performed in the same device as the learning operation of the object placement model according to FIG. 2 and may be performed by different devices.

Referring to FIG. 7, the object placement model 113 generated by the object placement model provision device 100 may be stored in the memory 110 (S710).

The input interface may receive an arrangement request for a predetermined object from a user of the interior design service (S720).

The control module 125 may generate a variable specifying information on a state of a virtual space of a user and information on a predetermined object, and then determine a placement space of a predetermined object in the virtual space based on a control action output by inputting the variable to the object placement model (S730).

The above-described embodiment may provide an optimal object placement technology in consideration of the size occupied by an object in the virtual space of the interior design service, interference between objects, a type of objects placed together, a movement line of the virtual space, and the like based on the reinforcement learning.

The embodiments of the present disclosure may be achieved by various elements, for example, hardware, firmware, software, or a combination thereof.

In a hardware configuration, an embodiment of the present disclosure may be achieved by one or more application specific integrated circuits (ASICs), digital signal processors (DSPs), digital signal processing devices (DSDPs), programmable logic devices (PLDs), field programmable gate arrays (FPGAs), processors, controllers, microcontrollers, microprocessors, and the like.

In a firmware or software configuration, an embodiment of the present disclosure may be implemented in the form of a module, a procedure, a function, etc. Software code may be stored in a memory unit and executed by a processor. The memory unit is located at the interior or exterior of the processor and may transmit and receive data to and from the processor via various known elements.

Combinations of blocks in the block diagram attached to the present disclosure and combinations of operations in the flowchart attached to the present disclosure may be performed by computer program instructions. These computer program instructions may be installed in an encoding processor of a general-purpose computer, a special purpose computer, or other programmable data processing equipment, and thus the instructions executed by an encoding processor of a computer or other programmable data processing equipment may create an element for perform the functions described in the blocks of the block diagram or the operations of the flowchart. These computer program instructions may also be stored in a computer-usable or computer-readable memory that may direct a computer or other programmable data processing equipment to implement a function in a particular method, and thus the instructions stored in the computer-usable or computer-readable memory may produce an article of manufacture containing an instruction element for performing the functions of the blocks of the block diagram or the operations of the flowchart. The computer program instructions may also be mounted on a computer or other programmable data processing equipment, and thus a series of operations may be performed on the computer or other programmable data processing equipment to create a computer-executed process, and it may be possible that the computer program instructions provide the blocks of the block diagram and the operations for performing the functions described in the operations of the flowchart.

Each block or each step may represent a module, a segment, or a portion of code that includes one or more executable instructions for executing a specified logical function. It should also be noted that it is also possible for functions described in the blocks or the operations to be out of order in some alternative embodiments. For example, it is possible that two consecutively shown blocks or operations may be performed substantially and simultaneously, or that the blocks or the operations may sometimes be performed in the reverse order according to the corresponding function.

As such, those skilled in the art to which the present disclosure pertains will understand that the present disclosure may be embodied in other specific forms without changing the technical spirit or essential characteristics thereof. Therefore, it should be understood that the embodiments described above are illustrative in all respects and not restrictive. The scope of the present disclosure is defined by the following claims rather than the detailed description, and all changes or modifications derived from the meaning and scope of the claims and their equivalent concepts should be construed as being included in the scope of the present disclosure.

**Claims**

1. An object placement model provision device, comprising:

   one or more memories configured to store instructions for performing a predetermined operation; and
   one or more processors operatively connected to the one or more memories and configured to execute the instructions,
   wherein the operation performed by the processor includes:

   generating a learning environment as a target of reinforcement learning by setting variable constituting a state of a virtual space provided by an interior design service, a control action of changing a variable of the virtual space, an agent as a target object of the control action, placed in the virtual space, a policy defining an effect of a predetermined variable on another variable, and a reward evaluated based on the state of the virtual space changed by the control action;

generating a first neural network configured to train a value function predicting a reward to be achieved as a predetermined control action is performed in each state of the learning environment;

generating a second neural network configured to train a policy function determining a control action of maximizing a reward to be finally accumulated among control actions to be performed, based on a predicted value of the value function for each state changed by a control action to be performed in each state of the learning environment; and

performing reinforcement learning in a direction of minimizing a cost function of the first neural network and the second neural network.

2. The object placement model provision device of claim 1, wherein the variable includes:

a first variable specifying a location, an angle, and an area of a wall and a floor constituting the virtual space; and

a second variable specifying a location, an angle, and an area of an object placed in the virtual space.

3. The object placement model provision device of claim 2, wherein the first variable includes a position coordinate specifying a midpoint of the wall, a Euler angle specifying an angle at which the wall is disposed, a center coordinate of the floor, and polygon information specifying a boundary surface of the floor.

4. The object placement model provision device of claim 2, wherein the second variable includes a position coordinate specifying a midpoint of the object, size information specifying a size of a horizontal length/vertical length/width of the object, a Euler angle specifying an angle at which the object is disposed, and interference information used to evaluate interference between the object and another object.

5. The object placement model provision device of claim 4, wherein the interference information includes information on a space occupied by a polyhedral shape that protrudes by a volume obtained by multiplying an area of any one of surfaces of a hexahedron including a midpoint of the object within the size of the horizontal length/vertical length/width by a predetermined length.

6. The object placement model provision device of claim 2, wherein the policy classifies an object that is in contact with a floor or a wall in the virtual space to support another object among the objects, as a first layer, classifies an object that is in contact with an object of the first layer to be supported among the objects, and includes a first policy predefined with respect to a type of an object of the second layer that is associated and placed with a predetermined object of the first layer and is set as a relationship pair therewith, a placement distance between the predetermined object of the first layer and the object of the second layer as a relationship pair therewith, and a placement direction of the predetermined object of the first layer and the object of the second layer as a relationship pair therewith, a second policy predefining a range of a height at which a predetermined object is disposed, and a third policy predefining and recognizing a movement line that reaches all types of spaces from an entrance of the virtual space as an area with a predetermined width.

7. The object placement model provision device of claim 6, wherein the control action includes an operation of changing a variable for a location and an angle of the agent in the virtual space.

8. The object placement model provision device of claim 7, wherein the reward is calculated according to a plurality of preset evaluation equations for evaluating respective degrees to which the state of the learning environment, which is changed according to the control action, conforms to each of the first, second, and third policies, and is determined by combining respective weights determined as reflection ratios of the plurality of evaluation equations.

9. The object placement model provision device of claim 8, wherein the plurality of evaluation equations includes an evaluation score for a distance between objects in the virtual space, an evaluation score for a distance between object groups obtained after the object in the virtual space is classified into a group depending on the distance, an evaluation score for an alignment relationship between the objects in the virtual space, an evaluation score for an alignment relationship between the object groups, an evaluation score for an alignment relationship between the object group and the wall, an evaluation score for a height at which an object is disposed, an evaluation score for a free space of the floor, an evaluation score for a density of an object disposed on the wall, and an evaluation score for a length of a movement line.

10. An object placement model provision device comprising:

a memory configured to store an object placement model generated by a device of any one of claims 1 to 9;
an input interface configured to receive a placement request for a predetermined object from a user of an interior design service; and
a processor configured to generate a variable specifying information on a state of a virtual space of the user and information on the predetermined object and then determine a placement space for the predetermined object in the virtual space based on a control action output by inputting the variable to the object placement model.

11. An object placement model provision method performed by an object placement model provision device, the method comprising:

generating a learning environment as a target of reinforcement learning by setting variable constituting a state of a virtual space provided by an interior design service, a control action of changing a variable of the virtual space, an agent as a target object of the control action, placed in the virtual space, a policy defining an effect of a predetermined variable on another variable, and a reward evaluated based on the state of the virtual space changed by the control action;
generating a first neural network configured to train a value function predicting a reward to be achieved as a predetermined control action is performed in each state of the learning environment;
generating a second neural network configured to train a policy function determining a control action of maximizing a reward to be finally accumulated among control actions to be performed, based on a predicted value of the value function for each state changed by a control action to be performed in each state of the learning environment; and
performing reinforcement learning in a direction of minimizing a cost function of the first neural network and the second neural network.

12. A computer-readable recording medium having recorded thereon a computer program including an instruction causing a processor to perform the method of claim 11.

Fig. 1

100

110

MEMORY

111

BIG DATA DB

113

OBJECT PLACEMENT MODEL

115

INSTRUCTION DB

120

PROCESSOR

121

ENVIRONMENT SETTING MODEL

123

REINFORCEMENT LEARNING MODEL

125

CONTROL MODEL

130

INPUT INTERFACE

140

DISPLAY PART

150

COMMUNICATION INTERFACE

Fig. 2

```
                    ┌─────────┐
                    │  START  │
                    └────┬────┘
                         │
                         ▼
┌─────────────────────────────────────────────┐
│      GENERATE LEARNING ENVIRONMENT AS TARGET OF      │──S210
│           REINFORCEMENT LEARNING            │
└─────────────────────┬───────────────────────┘
                      │
                      ▼
┌─────────────────────────────────────────────┐
│      GENERATE FIRST NEURAL NETWORK THAT TRAINS       │
│      VALUE FUNCTION FOR PREDICTING REWARD TO BE      │──S220
│      ACHIEVED AS PREDETERMINED CONTROL ACTION I      │
│  PERFORMED IN EACH STATE OF LEARNING ENVIRONMENT     │
└─────────────────────┬───────────────────────┘
                      │
                      ▼
┌─────────────────────────────────────────────┐
│  GENERATE SECOND NEURAL NETWORK THAT TRAINS          │
│  POLICY FUNCTION DETERMINING CONTROL ACTION THAT     │
│  MAXIMIZES REWARD TO BE FINALLY ACCUMULATED          │
│  AMONG CONTROL ACTIONS TO BE PERFORMED BASED         │──S230
│  ON PREDICTED VALUE OF VALUE FUNCTION FOR EACH       │
│  STATE CHANGED BY CONTROL ACTION TO BE               │
│  PERFORMED IN EACH STATE OF LEARNING ENVIRONMENT     │
└─────────────────────┬───────────────────────┘
                      │
                      ▼
┌─────────────────────────────────────────────┐
│  TRAIN FIRST NEURAL NETWORK BY APPLYING GRADIENT     │
│  OF SECOND NEURAL NETWORK TO COST FUNCTION OF        │
│  FIRST NEURAL NETWORK AND TRAIN SECOND NEURAL        │──S240
│     NETWORK TO MINIMIZE COST FUNCTION OF            │
│           FIRST NEURAL NETWORK               │
└─────────────────────┬───────────────────────┘
                      │
                      ▼
                 ┌─────────┐
                 │   END   │
                 └─────────┘
```

15

Fig. 3

Fig. 4a

Fig. 4b

Fig. 4c

Fig. 5

| Constraint | Distance (in) | Direction |
|---|---|---|
| Bedside | 36 | To the side |
| Seat | 30 | In front |
| Cabinets and shelving | 24 | In front |
| Dining table | 36 | All around |
| Coffee table to seat | 16-18 | In front of seat |
| End table to seat | 0-12 | To the back or side of seat |
| Nightstand to bed | 0-12 | To the side of bed |

Fig. 6

Fig. 7

```
                        ┌──────────┐
                        │  START   │
                        └──────────┘
                             │
                             ▼
    ┌───────────────────────────────────────────────────┐
    │   STORE OBJECT PLACEMENT MODEL GENERATED BY        │
    │   OBJECT PLACEMENT MODEL PROVISION DEVICE          │──S710
    └───────────────────────────────────────────────────┘
                             │
                             ▼
    ┌───────────────────────────────────────────────────┐
    │   RECEIVE PLACEMENT REQUEST FOR PREDETERMINED      │
    │   OBJECT FROM USER OF INTERIOR DESIGN SERVICE      │──S720
    └───────────────────────────────────────────────────┘
                             │
                             ▼
    ┌───────────────────────────────────────────────────┐
    │   DETERMINE PLACEMENT SPACE OF PREDETERMINED       │
    │   OBJECT IN VIRTUAL SPACE BASED ON CONTROL         │
    │   ACTION OUTPUT BY INPUTTING INFORMATION ON        │──S730
    │   STATE OF VIRTUAL SPACE OF USER AND               │
    │   INFORMATION ON PREDETERMINED OBJECT TO           │
    │   OBJECT PLACEMENT MODEL                           │
    └───────────────────────────────────────────────────┘
                             │
                             ▼
                        ┌──────────┐
                        │   END    │
                        └──────────┘
```

## INTERNATIONAL SEARCH REPORT

International application No.

**PCT/KR2021/019629**

### A. CLASSIFICATION OF SUBJECT MATTER

**G06Q 50/08**(2012.01)i; **G06Q 50/10**(2012.01)i; **G06T 19/00**(2011.01)i; **G06F 30/20**(2020.01)i; **G06Q 10/06**(2012.01)i; **G06N 3/08**(2006.01)i

According to International Patent Classification (IPC) or to both national classification and IPC

### B. FIELDS SEARCHED

Minimum documentation searched (classification system followed by classification symbols)

G06Q 50/08(2012.01); G06F 30/00(2020.01); G06Q 10/04(2012.01); G06T 17/00(2006.01); G06T 19/00(2011.01); G06T 19/20(2011.01); H04N 13/10(2018.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 인테리어(interior), 사물(object), 시뮬레이션(simulation), 배치(placement), 강화학습(reinforcement learning)

### C. DOCUMENTS CONSIDERED TO BE RELEVANT

| Category* | Citation of document, with indication, where appropriate, of the relevant passages | Relevant to claim No. |
|---|---|---|
| X | KR 10-2019-0106867 A (LG ELECTRONICS INC.) 18 September 2019 (2019-09-18)<br>See paragraphs [0043]-[0073] and [0284]-[0338]; claims 1-3; and figures 1-2 and 8-15. | 1-3,6-12 |
| Y | | 4-5 |
| Y | KR 10-2017-0054068 A (SK TELECOM CO., LTD.) 17 May 2017 (2017-05-17)<br>See paragraphs [0021]-[0023] and [0044]; and figures 1-2 and 6. | 4-5 |
| A | KR 10-2019-0065933 A (YPA CO., LTD.) 12 June 2019 (2019-06-12)<br>See paragraphs [0017]-[0073]; claims 1-11; and figures 1-10. | 1-12 |
| A | US 2009-0160856 A1 (HOGUET, Ramsay) 25 June 2009 (2009-06-25)<br>See paragraphs [0181]-[0541]; claims 1-38; and figures 1-100. | 1-12 |
| A | US 2019-0026957 A1 (MATTERPORT, INC.) 24 January 2019 (2019-01-24)<br>See paragraphs [0061]-[0255]; claims 1-9; and figures 1-34. | 1-12 |

☐ Further documents are listed in the continuation of Box C.　☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **12 April 2022** | **12 April 2022** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2019)

**INTERNATIONAL SEARCH REPORT**
**Information on patent family members**

International application No.

**PCT/KR2021/019629**

| Patent document cited in search report | | | Publication date (day/month/year) | Patent family member(s) | | | Publication date (day/month/year) |
|---|---|---|---|---|---|---|---|
| KR | 10-2019-0106867 | A | 18 September 2019 | US | 2021-0064792 | A1 | 04 March 2021 |
| KR | 10-2017-0054068 | A | 17 May 2017 | KR | 10-2021-0124131 | A | 14 October 2021 |
| | | | | KR | 10-2325297 | B1 | 11 November 2021 |
| KR | 10-2019-0065933 | A | 12 June 2019 | KR | 10-2186899 | B1 | 04 December 2020 |
| | | | | WO | 2020-101339 | A1 | 22 May 2020 |
| US | 2009-0160856 | A1 | 25 June 2009 | US | 2008-0125892 | A1 | 29 May 2008 |
| | | | | US | 2008-0126020 | A1 | 29 May 2008 |
| | | | | US | 2008-0126021 | A1 | 29 May 2008 |
| | | | | US | 2008-0126022 | A1 | 29 May 2008 |
| | | | | US | 2008-0126023 | A1 | 29 May 2008 |
| | | | | US | 2009-0138113 | A1 | 28 May 2009 |
| | | | | US | 2012-0278047 | A1 | 01 November 2012 |
| | | | | US | 2013-0144567 | A1 | 06 June 2013 |
| | | | | US | 2013-0147799 | A1 | 13 June 2013 |
| | | | | US | 8117558 | B2 | 14 February 2012 |
| | | | | US | 8122370 | B2 | 21 February 2012 |
| | | | | US | 8253731 | B2 | 28 August 2012 |
| | | | | US | 8260581 | B2 | 04 September 2012 |
| | | | | US | 9019266 | B2 | 28 April 2015 |
| | | | | WO | 2008-067191 | A2 | 05 June 2008 |
| | | | | WO | 2008-067191 | A3 | 02 October 2008 |
| US | 2019-0026957 | A1 | 24 January 2019 | CN | 112771539 | A | 07 May 2021 |
| | | | | US | 10482679 | B2 | 19 November 2019 |
| | | | | US | 10529141 | B2 | 07 January 2020 |
| | | | | US | 10529142 | B2 | 07 January 2020 |
| | | | | US | 10529143 | B2 | 07 January 2020 |
| | | | | US | 10848731 | B2 | 24 November 2020 |
| | | | | US | 10909770 | B2 | 02 February 2021 |
| | | | | US | 11094137 | B2 | 17 August 2021 |
| | | | | US | 11164394 | B2 | 02 November 2021 |
| | | | | US | 2014-0043436 | A1 | 13 February 2014 |
| | | | | US | 2014-0125658 | A1 | 08 May 2014 |
| | | | | US | 2014-0125767 | A1 | 08 May 2014 |
| | | | | US | 2014-0125768 | A1 | 08 May 2014 |
| | | | | US | 2014-0125769 | A1 | 08 May 2014 |
| | | | | US | 2014-0125770 | A1 | 08 May 2014 |
| | | | | US | 2018-0139431 | A1 | 17 May 2018 |
| | | | | US | 2019-0026956 | A1 | 24 January 2019 |
| | | | | US | 2019-0026958 | A1 | 24 January 2019 |
| | | | | US | 2019-0035165 | A1 | 31 January 2019 |
| | | | | US | 2019-0394441 | A1 | 26 December 2019 |
| | | | | US | 2021-0166495 | A1 | 03 June 2021 |
| | | | | US | 9324190 | B2 | 26 April 2016 |
| | | | | WO | 2018-140656 | A1 | 02 August 2018 |
| | | | | WO | 2020-069049 | A1 | 02 April 2020 |

Form PCT/ISA/210 (patent family annex) (July 2019)